# EUROPÄISCHE PATENTSCHRIFT

(11) **EP 2 745 996 B1**
(45) Veröffentlichungstag und Bekanntmachung des Hinweises auf die Patenterteilung: **24.08.2016**
(21) Anmeldenummer: 13005412.5
(22) Anmeldetag: 18.11.2013
(51) Int. Cl.: B25H 3/00, G07F 11/00

(54) **Einrichtung zum Lagern von in Gurtspulen aufgenommenen elektrischen Bauelementen**
Device for mounting electrical components in belt coils
Dispositif de logement d'éléments de construction électriques logés dans des bobines de ceinture

(30) Priorität: 21.12.2012 DE 102012025424
(43) Veröffentlichungstag der Anmeldung: 25.06.2014
(73) Patentinhaber: MIMOT GmbH, 79539 Lörrach (DE)
(72) Erfinder: Philipp, Jürgen, 79639 Grenzach-Whylen (DE)
(74) Vertreter: Müller Hoffmann & Partner

(56) Entgegenhaltungen:
- DE-A1- 19 509 951
- DE-U1-202004 004 292
- DE-U1-202004 006 920

## Beschreibung

Die Erfindung bezieht sich auf eine Einrichtung zum Lagern und Bereitstellen von in Gurtspulen aufgenommenen elektrischen Bauelementen für elektronische Geräte, wobei die Gurtspulen in einer Übergabestation der Einrichtung bereitstellbar und in Ablagefächern einer Regaleinrichtung ablegbar sind, wobei die Gurtspulen mittels zumindest eines Schiebers in einer Einschubrichtung in die Ablagefächer einschiebbar sind und wobei der Schieber quer zur Einschubrichtung verfahrbar ist und wobei die Einrichtung Abtastmittel zum Ermitteln von Abmessungen der Gurtspule aufweist.

Ein derartige Einrichtung ist z.B. durch die DE202004006920 U1 bekannt geworden. Danach ist der der in der Höhe positionierbare Schieber als Greifer ausgebildet, der um eine zentrale senkrechte Achse drehbar und radial verschiebbar ist. Die Ablagefächer sind um die Greiferachse zirkulär verteilt angeordnet und zu dieser hin offen. Die mit einer zentralen Bohrung versehenen scheibenförmigen Gurtspulen werden in eine Eingabeöffnung der Einrichtung flach liegend eingelegt, wo ihr Durchmesser und/oder ihre Dicke mittels einer entsprechenden Einrichtung erfasst werden kann. Die Gurtspule wird zwischen zwei parallelen flachen Greifelementen des Greifers eingeklemmt und fixiert. Der Greifer wird sodann in Winkel und Höhe auf die Zielkoordinaten des Ablagefachs eingestellt und radial zum Ablagefach verschoben. Bei diesen Bewegungen muss die Klemmkraft der Greifelemente so hoch sein, dass die Gurtspule bei den vorgegebenen Beschleunigungen am Greifer nicht verrutscht.

Die Spulenkörper können in ihrer Oberflächenbeschaffenheit und Geometrie große Unterschiede im Hinblick auf die kraftschlüssige Klemmung aufweisen. In sich verformte Spulenkörper können nicht definiert gehalten werden. Insbesondere Spulenkörper aus Pappe können erheblich verformt sein, so dass es beim Einschieben in die Ablagefächer zu Kollisionen kommen kann.

Der Erfindung liegt die Aufgabe zugrunde, die Ablagesicherheit zu erhöhen und die Greiferbewegungen zu beschleunigen.

Diese Aufgabe wird durch die Erfindung gemäß Anspruch 1 gelöst. Die Erfassung der Abmessungen und der Lage der Gurtspulen erstreckt sich auf am Greifer fixierte Gurtspulen, insbesondere auf deren Randbereiche. Die ermittelten Korrekturwerte ermöglichen es, die Gurtspulen in zur Größe passenden Ablagefächern zielgenau abzulegen. Beim Abholen können mechanische Fixiermittel des als Greifer dienenden Schiebers genau auf die Gurtspule ausgerichtet werden, so dass die Gurtspule sicher gehalten und ohne die Gefahr des seitlichen Verrutschens beschleunigt bzw. gebremst werden kann. Die optische Abtastung der am Greifer lageabweichend gehaltenen Gurtspule ermöglicht die optimale Zuordnung zum und Ausrichtung auf das Ablagefach z.B. in seiner Höhenlage, wobei die Querrichtung einer senkrechten Verschieberichtung der Positioniereinrichtung entspricht. Durch die genaue Zentrierung der Gurtspulen auf die Ablagefächer ist es möglich, deren Querschittsabmessungen zu verringern und damit die Kapazität der Regaleinrichtung zu erhöhen

Weiterbildungen der Erfindung sind in den Ansprüchen 2 bis 7 gekennzeichnet.

Die Weiterbildungen nach den Ansprüchen 2 und 3 ermöglichen die optische Abtastung mit geringem Aufwand.

Durch die Weiterbildungen nach den Ansprüchen 4 und 5 kann insbesondere die Höhenlage und Dicke des kritischen Randbereichs der Gurtspule erfasst werden. Insbesondere aus Pappe bestehende Spulenkörper können in sich so stark verformt sein, dass sie beim unkorrigierten Einschieben in das Ablagefach an dessen frontseitige Ränder anstoßen können, was bei der entsprechenden Lagekorrektur sicher vermieden werden kann.

Der Zentrierstift nach Anspruch 6 stellt ein einfaches Zentriermittel zum Eingriff in eine zentrale Bohrung des Spulenkörpers dar.

Durch die Weiterbildung nach Anspruch 7 ist es möglich, den Zentrierstift soweit am Schieber zu versenken bzw. herauszuschieben, dass dieser beim Abholen oder Ablegen der Gurtspule nur eine geringe Hubbewegung ausführen muss.

Im Folgenden wird die Erfindung anhand eines in der Zeichnung dargestellten Ausführungsbeispieles näher erläutert. Es zeigen:
Figur 1 eine perspektivische Rückansicht einer Einrichtung zum Lagern von in Gurtspulen aufgenommenen elektrischen Bauelementen,
Figur 2 eine Seitenansicht eines Schiebers der Einrichtung nach Figur 1,
Figur 3 eine Seitenansicht einer Zentrierstation der Einrichtung nach Figur 1 mit dem Schieber und einer daran gehaltenen Gurtspule
Figur 4 eine Rückansicht der Teile nach Figur 3,

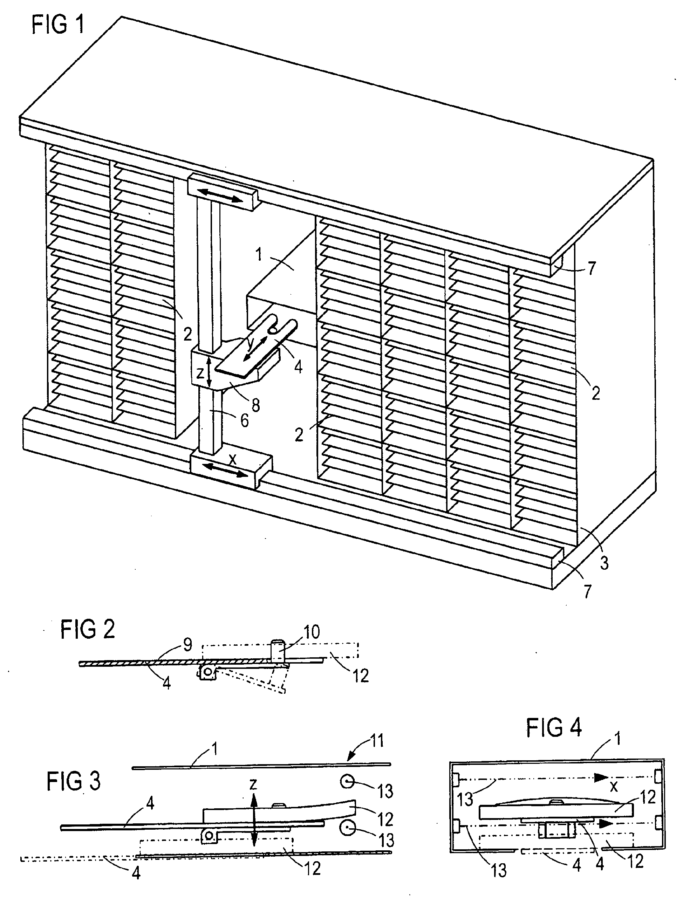

Figur 1 zeigt schematisiert eine Einrichtung zum Lagern und Bereitstellen von in Gurtspulen 12 (Fig. 3) aufgenommenen elektrischen Bauelementen. Die Gurtspulen können in eine nicht dargestellte frontseitigen Eingabestation z.B. von Hand eingelegt und vorn dort zu einer Übergabestation 1 der Einrichtung transportiert werden, von wo aus sie in Ablagefächern 2 einer Regaleinrichtung 3 abgelegt werden können, wobei die Gurtspulen mittels eines Schiebers 4 in einer waagerechten Einschubrichtung y in die Ablagefächer 2 einschiebbar sind. Der Schieber 4 ist quer zur Einschubrichtung entlang der Regaleinrichtung 3 mittels einer orthogonalen Positioniereinrichtung verfahrbar und auf die einzelnen Fächer der flachen Regaleinrichtung 3 einstellbar. Die Positioniereinrichtung weist einen senkrechten schlanken Träger 6 auf, der in einer stationären Längsführung 7 der Einrichtung in einer waagerechten Längsrichtung y verfahrbar ist. Am Träger 6 ist in einer senkrechten Richtung z ein Wagen 8 verschiebbar, an dem der Schieber 4 in der Einschubrichtung y verschiebbar geführt ist.

Nach Figur 2 weist der Schieber 4 eine ebene obere Auflagefläche 9 zum Auflegen einer scheibenartigen Gurtspule 12 mit darin gespeicherten elektrischen Bauelementen auf. Ein am Schieber 4 schwenkbar gelagerter Zentrierstift 10 ragt nach oben senkrecht aus der Auflagefläche 9 heraus und spielarm in eine zentrale Bohrung der Gurtspule 12 hinein. Er ist nach unten in die strichpunktiert angedeutete Stellung versenkbar.

Nach den Figuren 3 und 4 weist die Übergabestation 1 optische Abtastmittel in Form einer optischen Zentrierstation 11 auf, die durch zwei zueinander parallele übereinanderliegende Lichtschranken 13 gebildet ist, die in der waagerechten Längsrichtung x quer zu Einschubrichtung y orientiert sind. Die Gurtspule 12 wird in der strichpunktiert angedeuteten Lage bereitgestellt und dort vom Schieber 4 aufgenommen und in den Bereich der Zentrierstation 11 soweit verschoben, bis ihr vorderer Randbereich die Lichtschranken 13 erreicht.

Die Gurtspule 12 ist in sich so stark verbogen, dass der vordere Randbereich von der Auflagefläche 9 nach oben abgehoben ist. Durch maßkontrolliertes Anheben und Absenken des Schiebers 4 in der senkrechten Richtung z bis zum Unterbrechen der Lichtschranken 13 kann in die Lage des oberen und des unteren Randes der Gurtspule 12 in diesem Abschnitt bestimmt werden, woraus nicht nur die Höhenlage, sondern auch die Dicke der entsprechenden Querschnittskontur ermittelt werden kann, woraus sich entsprechende Korrekturwerte für die Positionierung des Schiebers ergeben. Nach dem Herausziehen des Schiebers 4 mit der Gurtspule 12 aus der Übergabestation 1 wird der Schieber 4 mittels der Positioniereinrichtung vor das ausgewählte Ablagefach 2 verfahren. Die Höhenlage des Schiebers 4 kann dabei mit den ermittelten Messdaten so korrigiert werden, dass der dem Ablagefach 2 zugewandte vermessene Randbereich der aufliegenden Gurtspule 12 in seiner Höhenlage auf die Öffnung des Ablagefachs 2 zentriert und kollisionsfrei eingeschoben werden kann.

### Bezugszeichen

- x: Längsrichtung
- y: Einschubrichtung
- z: senkrechte Richtung
- 1: Übergabestation
- 2: Ablagefach
- 3: Regaleinrichtung
- 4: Schieber
- 6: Träger
- 7: Längsführung
- 8: Wägen
- 9: Auflagefläche
- 10: Zentrierstift
- 11: Zentrierstation
- 12: Gurtspule
- 13: Lichtschranke

## Patentansprüche

1. Einrichtung zum Lagern und Bereitstellen von in zumindest einer Gurtspule (12) aufgenommenen elektrischen Bauelementen für elektronische Geräte,
wobei die Gurtspule (12) in einer Übergabestation (1) der Einrichtung bereitstellbar und in Ablagefächern (2) einer Regaleinrichtung (3) ablegbar ist,
wobei die Gurtspule (12) mittels zumindest eines Schiebers (4) in einer Einschubrichtung (y) in die Ablagefächer (2) einschiebbar ist,
wobei der Schieber (4) mittels einer Positioniereinrichtung in einer zur Einschubrichtung (y) senkrechten Querrichtung verfahrbar ist und
wobei die Einrichtung Abtastmittel zum Ermitteln von Abmessungen der Gurtspule (12) aufweist,
**dadurch gekennzeichnet,**
**dass** die Abtastmittel als stationäre optische Abtastmittel zum Ermitteln von Abmessungen und der Lage der auf dem Schieber (4) gehaltenen Gurtspule (12) ausgebildet sind und dass der Schieber (4) mit Gurtspule im Erfassungsbereich der optischen Abtastmittel in der Querrichtung (x) auslenkbar ist und dass eine Steuerung des Schiebers (4) in der senkrechten Querrichtung beim Aufnehmen und/oder beim Einschieben der Gurtspule (12) entsprechende Korrekturwerte ausgibt.

2. Einrichtung nach Anspruch 1, **dadurch gekennzeichnet,**
**dass** durch die Abtastmittel sich senkrecht zur Einschubrichtung (y) erstreckende Querschnittskonturen der Gurtspule (12) abtastbar sind.

3. Einrichtung nach Anspruch 2, **dadurch gekennzeichnet,**
**dass** die Abtastmittel einer im Bewegungsbereich des Schiebers (4) gelegene Zentrierstation (11) zugeordnet und als Lichtschranken (13) ausgebildet sind, deren Abstand zueinander größer ist als die Weite der abzutastenden Querschnittskontur,
**dass** die abzutastende Gurtspule (12) mittels des Schiebers (4) zwischen die entsprechend beabstandeten Lichtschranken(13) schiebbar ist und
**dass** der Schieber (4) in dieser Lage quer zur Einschubrichtung (y) soweit bewegbar ist, dass der Außenrand der Gurtspule (12) die Lichtschranken 13 erreicht.

4. Einrichtung nach Anspruch 3, **dadurch gekennzeichnet,**
**dass** die Lichtschranken (13) parallel zur einer ebenen Auflagefläche (9) des Schiebers (4) für die Gurtspule (12) orientiert sind und dass der Schieber (4) senkrecht zur Auflagefläche (9) bewegbar ist.

5. Einrichtung nach Anspruch 4, **dadurch gekennzeichnet,**
**dass** die abzutastende Querschnittkontur im dem Ablagefach (2) zugewandten Randbereich der Gurtspule (12) vor dem Einschieben liegt.

6. Einrichtung nach einem der vorhergehenden Ansprüche, **dadurch gekennzeichnet,**
**dass** der Schieber (4) einen Fixierstift (10) zum Eingreifen in eine zentrale Bohrung der Gurtspule (12) aufweist.

7. Einrichtung nach Anspruch 6, **dadurch gekennzeichnet,**
**dass** der Fixierstift (10) senkrecht zur Auflagefläche (9) orientiert und zumindest annähernd in seiner Achsrichtung aus der Auflagefläche (9) heraus schiebbar ist.

## Claims

1. Device for storage and provision of electrical components for electronic equipment mounted on at least one belt spool (12),
wherein the belt spool (12) can be provided in a transfer station (1) of the device and can be stored in storage compartments (2) of a racking equipment (3),
wherein the belt spool (12) can be inserted into the storage compartments (2) in an insertion direction (y) by at least one slider (4),
wherein the slider (4) can be moved by means of a positioning device in a transverse direction perpendicular to the insertion direction (y) and wherein the device has scanning means to determine the dimensions of the belt spool (12),
**characterised in that**
the scanning means is configured as static optical scanning means for determining dimensions and the position of the belt spool (12) held on the slider (4) and that the slider (4) with the belt spool can be deflected in the transverse direction (x) in the detection area of the optical scanning means (x) and that a control system of the slider (4) outputs correction values during mounting and/or insertion of the belt spool (12).

2. Device in accordance with claim 1, **characterised in that**
cross sectional contours of the belt spool (12) extending perpendicular to the insertion direction (y) in the transverse direction can be scanned by the scanning means.

3. Device in accordance with claim 2, **characterised in that**
the scanning means and are associated with a centring station (11) positioned in the zone of movement of the slider (4) are configured as photoelectric sensors (13) whose spacing is larger than the width of the cross section contour to be scanned,
the belt spool (12) to be scanned can be slid by means of the slider (4) between the correspondingly spaced photoelectric sensors (13) and that the slider (4) can be moved in this position transverse to the insertion direction (y) so far that the outer edge of the belt spool (12) reaches the photoelectric sensors (13).

4. Device in accordance with claim 3, **characterised in that**
the photoelectric sensors (13) are oriented parallel to a flat supporting surface (9) of the slider (4) for the belt spool (12) and that the slider (4) can be moved perpendicular to the supporting surface (9).

5. Device in accordance with claim 4, **characterised in that**
the cross sectional contour to be scanned is in the edge region of the belt spool (12) facing the storage compartment (2) before insertion.

6. Device in accordance with one of the preceding claims, **characterised in that**
the slider (4) has a fixing pin (10) which engages in a central bore of the belt spool (12).

7. Device in accordance with claim 6, **characterised in that**
the fixing pin (10) is oriented perpendicular to the supporting surface (9) and can be retracted at least approximately in its axial direction from the supporting surface (9).

## Revendications

1. Dispositif pour le stockage et la préparation d'éléments électriques pour appareils électroniques, logés dans au moins une bobine à bande (12),
étant précisé que la bobine à bande (12) est apte à être mise en place dans une station de transfert (1) du dispositif et est apte à être déposée dans des casiers (2) d'un dispositif à rayonnage (3),
que la bobine à bande (12) est apte à être insérée dans les casiers (2) dans un sens d'insertion (y) à l'aide d'au moins un coulisseau (4),
que le coulisseau (4) est apte à être déplacé dans un sens transversal perpendiculaire au sens d'insertion (y) à l'aide d'un dispositif de positionnement, et
que le dispositif comporte des moyens d'exploration pour déterminer les dimensions de la bobine à bande (12),
**caractérisé en ce que** les moyens d'exploration sont conçus comme des moyens d'exploration optiques stationnaires pour déterminer les dimensions et la position de la bobine à bande (12) maintenue sur le coulisseau (4), et **en ce que** le coulisseau (4) avec la bobine à bande est apte à être dévié dans le sens transversal (x) dans la zone de détection des moyens d'exploration optiques, et **en ce qu'**une commande du coulisseau (4) dans le sens transversal perpendiculaire quand la bobine à bande (12) est prise et/ou insérée émet des valeurs de correction correspondantes.

2. Dispositif selon la revendication 1, **caractérisé**
**en ce que** grâce aux moyens d'exploration, les contours de section transversale de la bobine à bande (12) qui s'étendent perpendiculairement au sens d'insertion (y) sont aptes à être explorés.

3. Dispositif selon la revendication 2, **caractérisé**
**en ce que** les moyens d'exploration sont associés à une station de centrage (11) qui se trouve dans la zone de déplacement du coulisseau (4), et sont conçus comme des barrières lumineuses (13) dont l'écartement mutuel est plus grand que la largeur du contour de section transversale à explorer,
**en ce que** la bobine à bande (12) à explorer est apte à être glissée à l'aide du coulisseau (4) entre les barrières lumineuses (13) espacées en conséquence, et
**en ce que** le coulisseau (4), dans cette position, est apte à être déplacé transversalement par rapport au sens d'insertion (y) jusqu'à ce que le bord extérieur de la bobine à bande (12) atteigne les barrières lumineuses (13).

4. Dispositif selon la revendication 3, **caractérisé**
**en ce que** les barrières lumineuses (13) sont orientées parallèlement à une surface d'appui (9) plane du coulisseau (4) pour la bobine à bande (12), et en ce que le coulisseau (4) est apte à être déplacé perpendiculairement à la surface d'appui (9).

5. Dispositif selon la revendication 4, **caractérisé**
**en ce que** le contour de section transversale à explorer se trouve dans la zone de bordure, tournée vers le casier (2), de la bobine à bande (12), avant l'insertion.

6. Dispositif selon l'une des revendications précédentes, **caractérisé**
**en ce que** le coulisseau (4) comporte une tige de fixation (10) destinée à pénétrer dans un perçage central de la bobine à bande (12).

7. Dispositif selon la revendication 6, **caractérisé**
**en ce que** la tige de fixation (10) est orientée perpendiculairement à la surface d'appui (9) et est apte à coulisser au moins approximativement dans son sens axial hors de ladite surface d'appui (9).
